Europäisches Patentamt

European Patent Office

Office européen des brevets

(11) Veröffentlichungsnummer: **0 236 258**
**B1**

(12) **EUROPÄISCHE PATENTSCHRIFT**

(45) Veröffentlichungstag der Patentschrift:
20.06.90

(21) Anmeldenummer: 87730016.0

(22) Anmeldetag: 17.02.87

(51) Int. Cl.⁵: **H03M 1/20**

(54) Verfahren zur Wandlung eines analogen Signals in ein digitales Signal.

(30) Priorität: **19.02.86 DE 3605701**

(43) Veröffentlichungstag der Anmeldung:
**09.09.87 Patentblatt 87/37**

(45) Bekanntmachung des Hinweises auf die Patenterteilung:
**20.06.90 Patentblatt 90/25**

(84) Benannte Vertragsstaaten:
**BE CH DE FR GB IT LI NL**

(56) Entgegenhaltungen:
**EP-A- 0 142 907**
**US-A- 3 562 420**
**US-A- 3 879 724**

**ELECTRONICS INTERNATIONAL, Band 53, Nr. 20, 11. September 1980, Seiten 171-172, New York, US; L.M. LOWE: "8-bit a-d converter has 12-bit linearity"**

(73) Patentinhaber: **Siemens Aktiengesellschaft, Wittelsbacherplatz 2, D-8000 München 2(DE)**

(72) Erfinder: **Lesche, Wolfgang Dipl.-Ing, Wildbergweg 13, D-1000 Berlin 37(DE)**

**Beschreibung**

Die Erfindung bezieht sich auf ein Verfahren zur Wandlung eines analogen Signals in ein digitales Signal mit einem Analog-Digital-Wandler, bei dem

a) zu dem analogen Signal eine sich zeitlich ändernde Störfunktion mit vorgegebener Zeitdauer addiert und so ein analoges Summensignal gebildet wird,

b) innerhalb der vorgegebenen Zeitdauer mehrere Wandlungsvorgänge des analogen Summensignals vorgenommen werden und

c) die bei den Wandlungsvorgängen gewonnenen digitalen Zwischengrößen addiert werden und ein erster arithmetischer Mittelwert über die Anzahl der Wandlungsvorgänge gebildet wird.

Ein derartiges Verfahren ist beispielsweise aus der EP-A2 0 142 907 bekannt. Bei diesem Verfahren wird das analoge Signal, welches ein bekanntes Frequenzband aufweist, in einem Abtast- und Haltekreis mit der doppelten Signalfrequenz abgetastet. Jedem Abtastwert wird zur Verbesserung des Auflösungsvermögens des Wandlers das Signal eines Störgrößengenerators - z.B. eine Treppenfunktion - über eine vorgegebene Zeitdauer überlagert. Die Störfunktion ist so gewählt, daß ihr Mittelwert bezüglich des abgetasteten Analogwertes Null ist. Auch bei anderen Verläufen der Störfunktion, beispielsweise als Sägezahn- oder Doppelrampe, muß die Störfunktion so erzeugt werden, daß sie über die vorgegebene Zeitdauer einen Mittelwert von Null aufweist. In dem digitalen Signal ist dann der Einfluß der Störfunktion kompensiert.

Für die Kompensation der Störgröße nach dem bekannten Verfahren ist daher die Erzeugung einer Störfunktion erforderlich, deren Verlauf exakt einem vorgegebenen folgt und deren Mittelwert über der vorgegebenen Zeitdauer Null ist. Bei Abweichungen hiervon können ansonsten nicht als solche erkennbare Nullpunktverschiebungen des digitalen Signals auftreten.

Aus der US-A 3 877 022 ist ebenfalls ein Verfahren zur Analog-Digital-Wandlung bekannt, bei dem das Auflösungsvermögen des Wandlers durch Aufprägen einer Störfunktion erhöht wird. Es handelt sich hierbei um die Aufprägung von «weissem Rauschen». Dieses an sich ist zwar relativ einfach herstellbar; im vorliegenden Falle muß es jedoch - damit sein Einfluß auf das digitale Signal kompensiert wird - zum einen ein ganz bestimmtes Frequenzband mit konstanter Amplitude abdecken und zum anderen außerhalb dieses Frequenzbandes eine statistische Amplituden- und Energiedichte von Null aufweisen. Ein derartiges Rauschsignal ist jedoch schwer zu erzeugen, zudem relativ viele Größen ständig kontrolliert werden müssen.

Ein weiteres bekanntes Verfahren zur Wandlung eines analogen Signals in ein digitales Signal ist der Zeitschrift «Electronics International» Vol. 53 (1980) Sept., Nr. 20, S. 171 und 172 entnehmbar. Bei diesem bekannten Verfahren wird mittels eines Pseudozufallsfolgengenerators ein digitales Störsignal erzeugt, das über einen Digital-Analog-Wandler einem Subtrahierer zugeführt wird; an diesem liegt auch das zu wandelnde analoge Eingangssignal. Das Ausgangssignal des Subtrahierers wird über ein Abtast-Halte-Glied einem Analog-Digital-Wandler zugeführt, dem ein digitaler Addierer nachgeordnet ist. Der Addierer ist auch mit dem Ausgangssignal des Pseudozufallsfolgengenerators beaufschlagt. Bei diesem bekannten Verfahren verursacht die Digital-Analog-Wandlung einen besonderen Aufwand, weil diese Wandlung - wenn der durch sie verursachte Fehler relativ klein gehalten werden soll - mit feiner Auflösung erfolgen muß.

Bei einem Verfahren der eingangs beschriebenen Art werden erfindungsgemäß innerhalb der vorgegebenen Zeitdauer zusätzlich mehrere Wandlungsvorgänge der Störfunktion allein vorgenommen, die bei diesen Wandlungsvorgängen gewonnenen digitalen Störfunktion-Zwischengrößen addiert und in zusätzlicher arithmetischer Mittelwert über die Anzahl dieser Wandlungsvorgänge gebildet und dieser zusätzliche arithmetische Mittelwert von dem ersten arithmetischen Mittelwert unter Bildung des digitalen Signals subtrahiert.

Bei dem erfindungsgemäßen Verfahren können beliebige Störfunktionen verwendet werden, weil eine genaue Kenntnis der Störfunktion nicht mehr erforderlich ist. Durch Einbeziehung der Störfunktion in den Wandlungsvorgang als eine eigenständig zu wandelnde Größe und Bildung des zusätzlichen arithmetischen Mittelwertes daraus wird eine vollständige Kompensation des Störgrößeneinflusses auf das digitale Signal erreicht. Als Störfunktionen können solche mit exponentiellem oder unregelmäßigem Verlauf und auch solche mit einem konstanten Gleichanteil sowie periodische und unperiodische Funktionen verwendet werden. Derartige Funktionen lassen sich mit einfachen Mitteln erzeugen, so daß sich damit eine kostengünstige Analog-Digital-Wandlung durchführen läßt. Der Takt der Wandlung, d.h. die Anzahl der Wandlungsvorgänge, ist grundsätzlich von dem Takt der Wandlung des analogen Summensignals unabhängig, er kann von ihm verschieden oder durch eine gemeinsame Steuerung in Übereinstimmung gebracht worden sein.

Bei dem erfindungsgemäßen Verfahren können die Wandlungsvorgänge der Störfunktion mit einem zusätzlichen Analog-Digital-Wandler durchgeführt werden, so daß die Wandlungsvorgänge von Störfunktion und vom durch die Störfunktion veränderten analogen Signal völlig unabhängig voneinander ablaufen. Es hat sich aber als besonders vorteilhaft erwiesen, wenn die Wandlungsvorgänge auch mit dem Analog-Digital-Wandler für die Wandlung des durch die Störfunktion geänderten analogen Signals durchgeführt werden, so daß nur ein einziger Analog-Digital-Wandler erforderlich ist.

Zur Addition von analogem Signal und Störgröße können einfache Addierglieder verwendet werden. Vorteilhaft ist jedoch die Verwendung einer Spannungsteiler-Anordnung, die mit der Störfunktion beaufschlagt ist, zur Bildung des durch die Störfunktion veränderten analogen Signals mit einem Ende eines Spannungsteilers an dem analogen Signal liegt und zur Bereitstellung der Störfunktion für die zusätzlichen Wandlungsvorgänge mit einem Ende eines weiteren Spannungsteilers an Bezugspotential liegt. Eine derartige Spannungsteileranordnung ist preisgünstig, einfach im Aufbau und für die Durchführung des erfindungsgemäßen Verfahrens mit einer beliebig verlaufenden Störfunktion besonders geeignet.

Der erste arithmetische Mittelwert des analogen Summensignals bzw. der zusätzliche arithmetische Mittelwert der Störfunktion wird in vorteilhafter Weise gebildet, wenn nach einer weiteren Ausgestaltung des Erfindungsgedankens die Abgriffe der beiden Spannungsteiler abwechselnd mit dem Eingang des einen Analog-Digital-Wandlers verbindbar sind. Es wird so erreicht, daß nach einem erfolgten Wandlungsvorgang eines Abtastwertes des analogen Summensignals sofort der oder die Wandlungsvorgänge für den oder die Abtastwerte der Störgröße vorgenommen werden, so daß nahezu der wahre Störgrößenanteil erfaßt wird. Der am Ende der vorgegebenen Zeitdauer hieraus sich ergebende zusätzliche arithmetische Mittelwert ist so nahezu identisch mit dem wahren Mittelwertanteil der Störgröße in dem arithmetischen Mittelwert aus dem gewandelten analogen Summensignal.

Das beschriebene Verfahren kann schaltungstechnisch in unterschiedlicher Weise durchgeführt werden. Besonders einfach wird die Erfassung und Verarbeitung der einzelnen Größen jedoch, wenn nach einer Ausgestaltung einer Schaltungsanordnung zur Durchführung des Verfahrens erfindungsgemäß mit den Abgriffen der Spannungsteiler ein Multiplexer eines Mikrocomputers verbunden ist, in dem das Abtast-Halte-Glied und der Analog-Digital-Wandler integriert sind. So können in optimaler Weise der Multiplexer, das Abtast-Halte-Glied und der Analog-Digital-Wandler von dem Mikrocomputer gesteuert werden, wobei gleichzeitig in einem Rechenwerk des Mikrocomputers die Mittelwerte gebildet und voneinander subtrahiert werden. Dieser Aufbau der Schaltungsanordnung bietet sich insbesondere dann an, wenn ein Mikrocomputer mit integriertem Multiplexer verwendet wird.

Als besonders vorteilhaft hat es sich bei dieser Schaltungsanordnung zur Erzielung eines möglichst einfachen Aufbaus herausgestellt, wenn an dem einen Ende der Spannungsteiler-Anordnung ein Generator zur Erzeugung einer beliebigen Störfunktion angeschlossen ist, der von einem Ausgang des Mikrocomputers gesteuert ist. Da die von diesem Generator zu erzeugende Störfunktion eine beliebige Form aufweisen kann und beispielsweise nicht exakt linear sein muß, ist es weiterhin vorteilhaft, wenn der Generator ein Rampengenerator ist, der einen Kondensator und einen steuerbaren elektronischen Schalter, welcher insbesondere ein Feldeffekttransistor ist, enthält. So kann mit einfachen Mitteln eine Störfunktion in Form einer Rampe erzeugt werden, wobei es unerheblich ist, ob die ansteigende Flanke der Rampe nach einer Linearfunktion, oder nach einer Exponentialfunktion verläuft. Das erfindungsgemäße Verfahren ist jedoch keinesfalls auf die Verwendung einer Rampenfunktion als Störfunktion beschränkt.

In vielen Fällen kann die Genauigkeit des erfindungsgemäßen Verfahrens zur Wandlung eines analogen Signals in ein digitales Signal durch äußere Störvorgänge beeinträchtigt werden. Um eine derartige Beeinträchtigung zu vermeiden, ist es daher orteilhaft, die vorgegebene Zeit für die Wandlungsvorgänge so zu wählen, daß sie ein ganzzahliges Vielfaches der Periode äußerer Störvorgänge beträgt. Dies gilt vor allem hinsichtlich der Vermeidung von Einflüssen der Netzfrequenz auf die Genauigkeit der mit dem erfindungsgemäßen Verfahren durchgeführten Wandlungen.

Zur weiteren Erläuterung der Erfindung ist in

Figur 1 ein Ausführungsbeispiel einer Schaltungsanordnung zur Durchführung des erfindungsgemäßen Verfahrens und in

Figur 2 ein weiteres, besonders vorteilhaftes Ausführungsbeispiel einer Schaltungsanordnung zur Durchführung des Verfahrens dargestellt.

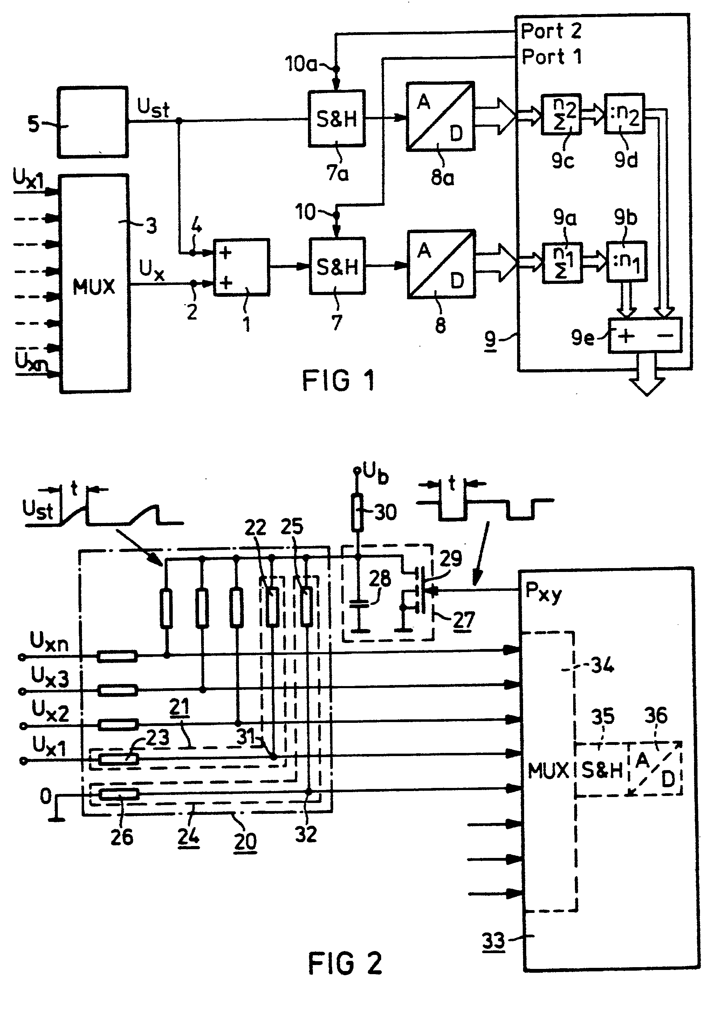

Die Schaltungsanordnung zur Durchführung des erfindungsgemäßen Verfahrens nach Fig. 1 enthält einen Summierer 1, dem an einem Eingang 2 über einen Multiplexer 3 zyklisch ein zu wandelndes Signal $U_x$ aus einer Anzahl von Eingangssignalen $U_{x1}$ bis $U_{xn}$ zugeführt wird. An einem weiteren Eingang 4 des Summierers 1 liegt eine Störfunktion $U_{st}$ an, die von einem Generator 5 erzeugt wird. Dem Summierer 1 ist ein Abtast-Halte-Glied 7 nachgeordnet, an dessen Ausgang ein Analog-Digital-Wandler 8 angeschlossen ist. Dieser Wandler 8 ist ausgangsseitig mit einem Rechnerbaustein 9 verbunden. Dieser Rechnerbaustein 9 ist über ein Port 1 mit einem Steuereingang 10 des Abtast-Halte-Gliedes 7 verbunden.

Ein weiteres Abtast-Halte-Glied 7a tastet direkt die von dem Generator 5 erzeugte Störfunktion $U_{st}$ ab und leitet diese abgetasteten Werte einem zusätzlichen Analog-Digital-Wandler 8a zu, der ebenfalls ausgangsseitig mit dem Rechnerbaustein 9 verbunden ist. Ein Port 2 des Rechnerbausteins 9 steuert das Abtast-Halte-Glied 7a über einen Steuereingang 10a, und zwar unabhängig von der Steuerung durch Port 1.

Die dargestellte Schaltung arbeitet in folgender Weise: Ist an dem Eingang 2 des Summierers 1 ein zu wandelndes analoges Signal in Form einer Spannung $U_x$ angelegt, dann wird dieser Spannung $U_x$ die Störfunktion $U_{st}$ überlagert. Das durch Addition entstandene Summensignal wird von dem Abtast-Halte-Glied 7 - gesteuert über Port 1 - in Abständen abgetastet. Die abgetasteten Werte werden nacheinander im Analog-Digital-Wandler 8 in $n_1$ Wandlungsvorgängen in digitale Zwischengrößen umgewandelt, die in dem Rechnerbaustein 9 in einer Addierstufe 9a addiert werden. Durch Division des Additionsergebnisses durch die Anzahl $n_1$ der Wandlungsvorgänge während einer vorgegebenen Zeitdauer wird im Rechnerbaustein 9 in einer Dividierstufe 9b ein erster arithmetischer Mittelwert gebildet. Dabei ist die vorgegebene Zeitdauer bestimmt durch die gewünschte Wandlungsgeschwindigkeit und -genauigkeit. Bei periodischen Störfunktionen kann deren Periodendauer auf die vorgegebene Zeitdauer abgestimmt sein.

Die Störfunktion $U_{st}$ wird von dem zusätzlichen Abtast-Halte-Glied 7a abgetastet und dem zusätzlichen Analog-Digital-Wandler 8a zugeführt. Dabei ist die in der vorgegebenen Zeitdauer durchgeführte Anzahl $n_2$ von Wandlungsvorgängen der Störfunktion von der Anzahl $n_1$ verschieden; es ist aber auch möglich, daß sie mit ihr übereinstimmt. Die $n_2$ Wandlungsvorgänge werden dann wiederum im Rechnerbaustein 9 einer Addierstufe 9c und einer Dividierstufe 9d zugeführt, die einen zusätzlichen arithmetischen Mittelwert über die Anzahl der $n_2$ Wandlungsvorgänge der Störfunktion während der vorgegebenen Zeitdauer ermitteln. Dieser Mittelwert und der erste arithmetische Mittelwert aus dem analogen Summensignal werden dann einem Subtraktionsglied 9e zugeführt, so daß das gewünschte digitale Signal unter Kompensation des Einflusses der Störfunktion gebildet wird.

Die Schaltungsanordnung nach Fig. 2 unterscheidet sich von der nach Fig. 1 u.a. dadurch, daß als Summierer eine Spannungsteiler-Anordnung benutzt wird, die - falls mehrere analoge Signale zyklisch gewandelt werden sollen - eine entsprechende Anzahl von Spannungsteilern aufweist.

In Fig. 2 ist in der Spannungsteiler-Anordnung 20 ein Spannungsteiler 21 von einem Widerstand 22 und einem weiteren Widerstand 23 gebildet und ein zusätzlicher Spannungsteiler 24 aus einem Widerstand 25 und einem weiteren Widerstand 26 zusammengesetzt. Das eine Ende der Spannungsteiler-Anordnung 20 ist an einen Generator 27 zur Erzeugung einer Störfunktion $U_{st}$ angeschlossen, der einen Kondensator 28 und einen steuerbaren elektronischen Schalter, beispielsweise einen Feldeffekttransistor 29, enthält. Über einen Widerstand 30 ist der Generator 27 an eine Versorgungsspannung $U_b$ anschließbar.

Die Abgriffe 31 und 32 der Spannungsteiler 21 und 24 sowie weitere Abgriffe ähnlich aufgebauter Spannungsteiler, an denen z. B. zu wandelnde analoge Signale $U_{x2}$, $U_{x3}$ bis $U_{xn}$ liegen können, sind mit Eingängen eines Mikrocomputers 33, z. B. des Typs SAB 80515 der Firma Siemens verbunden, und zwar mit Eingängen, die die Eingänge eines Multiplexers 34 darstellen. Diesem im Mikrocomputer 33 gebildeten eingangsseitigen Multiplexer 34 ist ein ebenfalls in den Mikrocomputer 33 integriertes Abtast-Halte-Glied 35 nachgeordnet, das einen nachfolgenden Analog-Digital-Wandler 36 beaufschlagt, der ebenfalls integraler Bestandteil des Mikrocomputers 33 ist. Bei dem Ausführungsbeispiel nach Fig. 2 ist also kein externer Multiplexer verwendet.

Von dem Mikrocomputer 33 wird über einen Ausgang $P_{xy}$ in einem der vorgegebenen Zeitdauer entsprechenden Takt - wie in Fig. 2 gezeigt - der Feldeffekttransistor 29 des Generators 27 betätigt, so daß an dem einen Ende der Spannungsteiler-Anordnung 20 eine rampenförmige Spannung $U_{st}$ als Störfunktion entsteht, wie sie in der Figur 2 schematisch angedeutet ist. Diese Rampenfunktion weist keine linearen Anstiegsflanken auf, sondern vielmehr solche mit exponentiellem Verlauf.

Die Wirkungsweise der Schaltungsanordnung nach Fig 2 entspricht im Prinzip der nach Fig. 1. Es wird beispielsweise während der vorgegebenen Zeitdauer durch den Multiplexer 34 die durch die Störgröße $U_{st}$ veränderte analoge Eingangsgröße $U_{x1}$ als Summensignal dem Abtast-Halte-Glied 35 zugeführt und in dem nachfolgenden Analog-Digital-Wandler 36 n-fach gewandelt. Die aus den einzelnen Wandlungsvorgängen gewonnenen digitalen Zwischengrößen werden dann in dem Rechnerbaustein 33 addiert, und es wird der arithmetische Mittelwert über die n Wandlungsvorgänge gebildet. Dabei wird nach jeder Abtastung der Spannung an dem Spannungsteiler 21 die dem zusätzlichen Spannungsteiler 24 aufgeprägte eigentliche Störfunktion $U_{st}$ durch den Multiplexer 34 an das Abtast-Halte-Glied 35 gelegt, danach n-fach gewandelt, addiert und unter Bildung des zusätzlichen arithmetischen Mittelwertes gemittelt. Beide Mittelwerte werden zur Erzeugung eines exakten, mit dem analogen Signal übereinstimmenden digitalen Signals voneinander subtrahiert.

Der besondere Vorteil einer derartigen Schaltungsanordnung ist darin zu sehen, daß trotz Verwendung einfachster Bauteile, wie beispielsweise Widerstände, Kondensatoren und elektronische Schalter, eine Analog-Digital-Wandlung vorgenommen werden kann, die durch die Aufprägung der Störfunktion einerseits eine verbesserte Wandlerkennlinie besitzt, andererseits aber nicht von der Exaktheit der Störfunktion abhängig ist, sondern beliebige Störfunktionen vollständig kompensieren kann, so daß ein digitales Signal erzeugt werden kann, das direkt mit dem analogen Signal übereinstimmt.

## Patentansprüche

1. Verfahren zur Wandlung eines analogen Signals ($U_x$) in ein digitales Signal mit einem Analog-Digital-Wandler (8), bei dem

a) zu dem analogen Signal ($U_x$) eine sich zeitlich ändernde Störfunktion ($U_{st}$) mit vorgegebener Zeitdauer addiert und so ein analoges Summensignal gebildet wird,

b) innerhalb der vorgegebenen Zeitdauer mehrere Wandlungsvorgänge des analogen Summensignals vorgenommen werden und

c) die bei den Wandlungsvorgängen gewonnenen digitalen Zwischengrößen addiert werden und ein erster arithmetischer Mittelwert über die Anzahl der Wandlungsvorgänge gebildet wird, dadurch gekennzeichnet, daß

e) innerhalb der vorgegebenen Zeitdauer zusätzlich mehrere Wandlungsvorgänge der Störfunktion ($U_{st}$) allein vorgenommen werden,

f) die bei diesen Wandlungsvorgängen gewonnenen digitalen Störfunktion-Zwischengrößen addiert und ein zusätzlicher arithmetischer Mittelwert über die Anzahl dieser Wandlungsvorgänge gebildet wird und

g) dieser zusätzliche arithmetische Mittelwert von dem ersten arithmetischen Mittelwert unter Bildung des digitalen Signals subtrahiert wird (Fig. 1).

2. Verfahren nach Anspruch 1, dadurch gekennzeichnet, daß

h) die Wandlungsvorgänge der Störfunktion ($U_{st}$) mit einem zusätzlichen Analog-Digital-Wandler (8a) durchgeführt werden (Fig. 1).

3. Verfahren nach Anspruch 1, dadurch gekennzeichnet, daß

i) die Wandlungsvorgänge der Störfunktion ($U_{st}$) mit dem Analog-Digital-Wandler (36) für die Wandlung des analogen Summensignals durchgeführt werden (Fig. 2).

4. Verfahren nach Anspruch 3, dadurch gekennzeichnet, daß

j) zur Addition von analogem Signal ($U_x$) und Störfunktion ($U_{st}$) eine Spannungsteiler-Anordnung (20) verwendet wird, die

j1) mit der Störfunktion ($U_{st}$) beaufschlagt ist,

j2) zur Bildung des analogen Summensignals mit einem Ende eines Spannungsteilers (21) an dem analogen Signal ($U_{xn}$) liegt und

j3) zur Bereitstellung der Störfunktion für die zusätzlichen Wandlungsvorgänge mit einem Ende eines weiteren Spannungsteilers (24) an Bezugspotential liegt (Fig. 2).

5. Verfahren nach Anspruch 4, dadurch gekennzeichnet, daß

k) die Abgriffe (31, 32) der beiden Spannungsteiler (21, 24) abwechselnd mit dem Eingang des Analog-Digital-Wandlers (36) verbindbar sind (Fig. 2).

6. Schaltungsanordnung zur Durchführung des Verfahrens nach Anspruch 5, dadurch gekennzeichnet, daß

l) mit den Abgriffen (31, 32) der Spannungsteiler (21, 24) ein Multiplexer (34) eines Mikrocomputers (33) verbunden ist, in dem

l1) das Abtast-Halte-Glied (35) und der Analog-Digital-Wandler (36) integriert sind (Fig. 2).

7. Schaltungsanordnung nach Anspruch 4, dadurch gekennzeichnet, daß

m) an dem anderen Ende der Spannungsteiler-Anordnung (20) ein Generator zur Erzeugung einer beliebigen Störfunktion ($U_{st}$) angeschlossen ist, der

m1) von einem Ausgang ($P_{xy}$) des Mikrocomputers (33) gesteuert ist (Fig. 2).

8. Schaltungsanordnung nach Anspruch 7, dadurch gekennzeichnet, daß

n) der Generator ein Rampen-Generator (27) ist, der einen Kondensator (28) und einen steuerbaren elektronischen Schalter enthält (Fig. 2).

9. Schaltungsanordnung nach Anspruch 8, dadurch gekennzeichnet, daß

o) der steuerbare elektronische Schalter ein Feldeffekttransistor (29) ist (Fig. 2).

10. Verfahren nach Anspruch 1, dadurch gekennzeichnet, daß

p) die vorgegebene Zeitdauer für die Wandlungsvorgänge so gewählt wird, daß sie ein ganzzahliges Vielfaches der Periode äußerer Störvorgänge beträgt.

## Claims

1. A process for converting an analog signal ($U_x$)

to a digital signal with an analog-digital converter (8), wherein

a) a time-variable interference function ($U_{st}$) lasting a predetermined period of time is added to the analog signal ($U_x$) so as to generate an analog summation signal,

b) within the predetermined period a plurality of conversion processes are performed on the analog summation signal and

c) the digital intermediate values obtained by the conversion processes are added and a first arithmetic mean value is generated over the number of conversion processes, characterised in that

e) within the predetermined period a plurality of conversion processes are performed on the interference function ($U_{st}$) alone,

f) the intermediate values of the digital interference function obtained by these conversion processes are added and an additional arithmetic mean value is generated over the number of these conversion processes, and

g) this additional arithmetic mean value is subtracted from the first arithmetic mean value during the generation of the digital signal (Fig. 1).

2. A process according to claim 1, characterised in that

h) the conversion processes on the interference function ($U_{st}$) are carried out by an additional analog-digital converter (8a) (Fig. 1).

3. A process according to claim 1, characterised in that

i) the conversion processes on the interference function ($U_{st}$) are carried out by the analog-digital converter (36) for the conversion of the analog summation signal (Fig. 2).

4. A process according to claim 3, characterised in that

j) a voltage divider arrangement (20) is used for the addition of the analog signal ($U_x$) and the interference function ($U_{st}$), which

j1) is acted on by the interference function ($U_{st}$),

j2) the analog signal ($U_{xn}$) is applied to one end of a voltage divider (21) to generate the analog summation signal, and

j3) for preparing the interference function for the additional conversion processes a reference potential is applied to one end of a further voltage divider (24) (Fig. 2).

5. A process according to claim 4, characterised in that

k) the taps (31, 32) of the two voltage dividers (21, 24) can be connected alternately to the input of the analog-digital converter (36) (Fig. 2).

6. A circuit arrangement for carrying out the process according to claim 5, characterised in that

l) the taps (31, 32) of the voltage divider (21, 24) have connected thereto a multiplexer (34) of a microcomputer (33) in which

l1) the sample-and-hold means (35) and the analog-digital converter (36) are integrated (Fig. 2)

7. A circuit arrangement according to claim 4, characterised in that

m) connected to the other end of the voltage divider-arrangement (20) there is a generator for producing a desired interference function ($U_{st}$), which is

m1) controlled from an output ($P_{xy}$) of the microcomputer (33) (Fig. 2).

8. A circuit arrangement according to claim 7, characterised in that

n) the generator is a ramp generator (27) which includes a capacitor (28) and a controllable electronic switch (Fig. 2).

9. A circuit arrangement according to claim 8, characterised in that

o) the controllable electronic switch is a field-effect transistor (29) (Fig. 2).

10. A process according to claim 1, characterised in that

p) the determined period for the conversion processes is selected so that it amounts to an integer multiple of the periods of external interference processes.

## Revendications

1. Procédé pour convertir un signal analogique ($U_x$) d'un signal numérique à l'aide d'un convertisseur analogique/numérique (8), et selon lequel

a) on ajoute au signal analogique ($U_x$) une fonction parasite variable dans le temps ($U_{st}$) possédant une durée prédéterminée et on forme ainsi un signal somme analogique,

b) on réalise plusieurs opérations de conversion du signal analogique somme pendant la durée prédéterminée, et

c) on additionne les grandeurs intermédiaires numériques obtenues lors des opérations de conversion et on forme une première valeur moyenne arithmétique sur le nombre des opérations de conversion, caractérisé par le fait que

e) pendant la durée prédéterminée, on exécute, en supplément, plusieurs opérations de conversion de la fonction parasite ($U_{st}$) seule,

f) on additionne les grandeurs intermédiaires numériques de la fonction parasite, obtenues lors de ces opérations de conversion, et on forme une valeur arithmétique moyenne supplémentaire sur le nombre de ces opérations de conversion, et

g) on soustrait cette valeur moyenne arithmétique supplémentaire, de la première valeur moyenne arithmétique en formant le signal numérique (figure 1).

2. Procédé suivant la revendication 1, caractérisé par le fait que

h) les opérations de conversion de la fonction parasite ($U_{st}$) sont exécutées au moyen d'un convertisseur analogique/numérique supplémentaire (8a) (figure 1).

3. Procédé suivant la revendication 1, caractérisé par le fait que

i) les opérations de conversion de la fonction parasite ($U_{st}$) sont exécutées par le convertisseur analogique/numérique (36) servant à convertir le signal somme analogique (figure 2).

4. Procédé suivant la revendication 3, caractérisé par le fait que

j) pour l'addition du signal analogique ($U_x$) et de la fonction parasite ($U_{st}$), on utilise un dispositif formant diviseur de tension (20), qui

j1) est chargé par la fonction parasite ($U_{st}$),

j2) reçoit, à une extrémité d'un diviseur de tension (21), le signal analogique ($U_{xt}$), pour la formation du signal somme analogique, et

j3) est raccordé, par une extrémité d'un autre diviseur de tension (24), au potentiel de référence, pour la délivrance de la fonction parasite pour les opérations de conversion supplémentaires (figure 2).

5. Procédé suivant la revendication 4, caractérisé par le fait que

k) les prises (31, 32) des deux diviseurs de tension (21, 24) peuvent être reliées alternativement à l'entrée du convertisseur analogique/numérique (36) (figure 2).

6. Montage pour la mise en oeuvre du procédé suivant la revendication 5, caractérisé par le fait que

l) aux prises (31, 32) des diviseurs de tension (21, 24) est relié un multiplexeur (34) d'un micro-ordinateur (33), dans lequel

l1) le circuit d'échantillonnage et de maintien (35) et le convertisseur analogique/numérique (36) sont intégrés (figure 2).

7. Montage suivant la revendication 4, caractérisé par le fait que

m) à l'autre extrémité du dispositif formant diviseur de tension (20) est raccordé un générateur qui sert à produire une tension parasite quelconque ($U_{st}$), qui

m1) est commandé par une sortie ($P_{xy}$) du micro-ordinateur (33) (figure 2).

8. Montage suivant la revendication 7, caractérisé par le fait que

n) le générateur est un générateur de signaux en rampe (27), qui contient un condensateur (21) et un interrupteur électronique commandable (figure 2).

9. Montage suivant la revendication 8, caractérisé par le fait que

o) l'interrupteur électronique commandable est un transistor à effet de champ (29) (figure 2).

10. Procédé suivant la revendication 1, caractérisé par le fait que

p) la durée prédéterminée pour les opérations de conversion est choisie de manière à être égale à un multiple entier de la période de processus parasites extérieurs.

FIG 1

FIG 2